**Europäisches Patentamt**

**European Patent Office**

**Office européen des brevets**

(19)

(11) **EP 1 079 233 A1**

## (12) DEMANDE DE BREVET EUROPEEN

(43) Date de publication:
**28.02.2001 Bulletin 2001/09**

(51) Int Cl.⁷: $G01R\ 27/04$

(21) Numéro de dépôt: **00402316.4**

(22) Date de dépôt: **18.08.2000**

(84) Etats contractants désignés:
**AT BE CH CY DE DK ES FI FR GB GR IE IT LI LU MC NL PT SE**
Etats d'extension désignés:
**AL LT LV MK RO SI**

(30) Priorité: **24.08.1999 FR 9910744**

(71) Demandeur: **THOMSON-CSF**
**75008 Paris (FR)**

(72) Inventeur: **Berranger, Robert**
**94117 Arcueil Cedex (FR)**

(54) **Procédé et dispositif pour la mesure d'impédance d'antenne**

(57) Le dispositif comprend :

- un transformateur courant/tension (1) couplé par son enroulement primaire entre un dispositif d'accord (2) d'une antenne (3) et la sortie d'un amplificateur (4) d'alimentation de l'antenne (3)
- un premier (5a) et un deuxième (5b) dispositif de transposition de fréquence numérique en bande de base couplé respectivement à la sortie de l'amplificateur (4) et à l'enroulement secondaire du transformateur (1),
- et un dispositif de calcul (7) pour calculer l'impédance de l'antenne (3) à partir des signaux fournis par le premier (5a) et le deuxième (5b) dispositif de transposition de fréquence.

Applications : Emetteurs HF large bande.

FIG.1

**Description**

La présente invention concerne un procédé et un dispositif pour la mesure d'impédance d'antenne radio-électrique émettant en haute fréquence dans une largeur de bande étendue.

L'utilisation en émission d'une antenne à large bande nécessite de disposer entre l'émetteur et l'antenne, un dispositif d'accord pour adapter l'impédance de sortie de l'amplificateur qui alimente l'antenne à l'impédance caractéristique de l'antenne.

La commande du dispositif d'accord s'effectue habituellement par approximations successives en contrôlant à chaque fois le taux d'onde stationnaire et la phase du signal à l'entrée du dispositif. L'accord est réalisé lorsque le taux d'onde stationnaire est descendu en dessous d'une valeur de seuil déterminée.

L'exécution d'un tel processus nécessite un grand nombre d'itérations qui prennent du temps et retardent d'autant l'émission du signal utile.

Par ailleurs les dispositifs de mesure du taux d'onde stationnaire mis en oeuvre sont rudimentaires et comme ils sont dimensionnés pour travailler dans de larges bandes de fréquences, des émetteurs proches géographiquement peuvent toujours perturber les mesures du fait de leur manque de sélectivité.

Le but de l'invention est de pallier les inconvénients précités :

A cet effet, l'invention a pour objet, un procédé de mesure d'une impédance d'antenne alimentée par un amplificateur, caractérisé en ce qu'il consiste :

- à transformer en tension la valeur du courant d'alimentation de l'antenne au moyen d'un transformateur dont l'enroulement primaire est traversé par le courant d'alimentation,
- à désaccoupler dans une première étape l'antenne de l'amplificateur pour charger l'amplificateur sur une résistance étalon Re au travers de l'enroulement primaire du transformateur en rendant égale la tension fournie par l'enroulement secondaire, à celle fournie par la sortie de l'amplificateur,
- puis à désaccoupler dans une deuxième étape la résistance étalon Re de la sortie de l'amplificateur en reconnectant l'antenne à la sortie de l'amplificateur au travers de l'enroulement primaire du transformateur pour calculer le module et l'argument de l'impédance Z de l'antenne en multipliant par la valeur de la résistance étalon Re le rapport des tensions fournies respectivement durant cette deuxième étape par la sortie de l'amplificateur et par l'enroulement secondaire du transformateur.

L'invention a également pour objet un dispositif pour la mise en oeuvre du procédé précité.

D'autres caractéristiques et avantages de l'invention apparaîtront dans la description qui suit faite en regard des dessins annexés qui représentent :

La figure 1 un mode de réalisation d'un dispositif de mesure d'impédance d'antenne selon l'invention.

La figure 2 un premier exemple de mise en oeuvre des dispositifs de transposition de fréquence de la figure 1.

La figure 3 un deuxième exemple de mise en oeuvre du dispositif de transposition de fréquence de la figure 1.

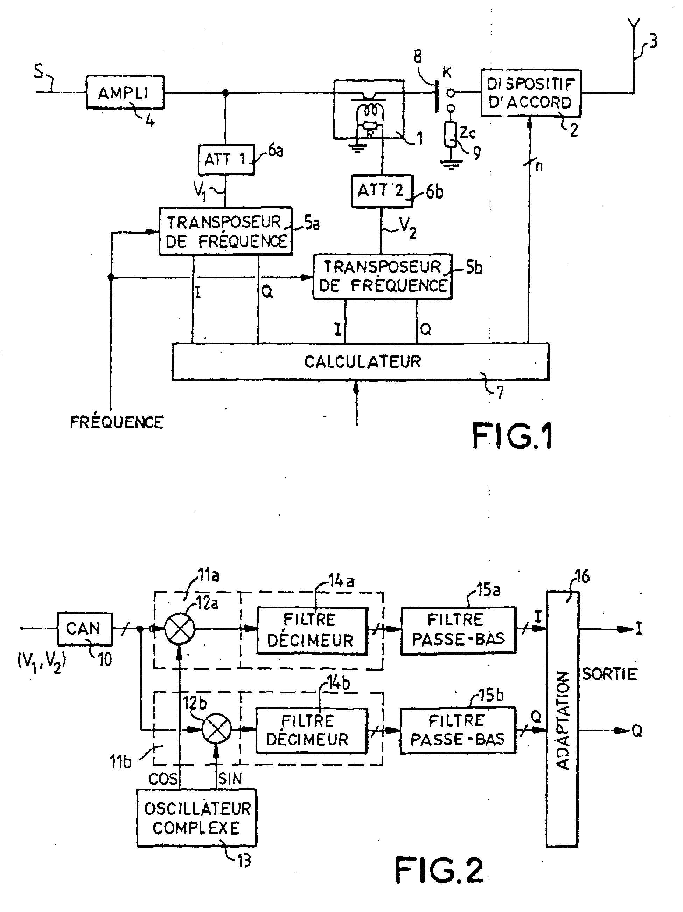

Le dispositif de mesure d'impédance d'antenne qui est représenté à la figure 1 comprend un transformateur courant/tension 1 à large bande couplé par son enroulement primaire entre un dispositif d'accord 2 d'une antenne 3 et la sortie d'un amplificateur AMPLI 4 de signaux S devant être appliqués sur l'antenne 3. Le dispositif de mesure comprend également deux dispositifs de transposition de fréquence numériques en bande de base 5a et 5b couplés respectivement, l'un 5a à la sortie de l'amplificateur 4 et l'autre 5b à l'enroulement du secondaire du transformateur 1 au travers respectivement d'atténuateurs ATT1 et ATT2 référencés respectivement 6a et 6b. Les deux dispositifs de transposition de fréquence 5a et 5b ont leurs sorties couplées respectivement à des entrées d'un dispositif de calcul 7 formé par un microprocesseur où tout dispositif équivalent. Les dispositifs 5a et 5b décomposent le signal appliqué sur leur entrée suivant deux signaux I et Q en quadrature, l'un 5a convertit directement la tension du signal obtenu à la sortie de l'amplificateur 4, tandis que l'autre convertit le courant du signal obtenu à la sortie de l'amplificateur 4 préalablement transformé en tension par le transformateur 1.

Le dispositif de calcul 7 est programmé pour effectuer le calcul de l'impédance d'entrée de l'antenne 3 à partir des signaux fournis sur les deux voies I et Q des deux dispositifs de transposition de fréquence 5a et 5b et commander le dispositif d'accord 2 pour réaliser l'adaptation d'impédance entre la sortie de l'amplificateur 4 et l'antenne 2. Un dispositif détalonnage composé d'un commutateur 8 et d'une impédance Zc est disposé entre le transformateur 1 et le dispositif d'accord 2.

Les dispositifs de transposition de fréquence 5a et 5b ont des structures identiques et sont composés comme le montre la figure 2 d'un convertisseur analogique numérique CAN 10 couplé à une chaîne de transposition composée de deux voies en quadrature 11a et 11b représentées à l'intérieur de deux lignes fermées en pointillés. Chacune des voies comprend un circuit multiplieur 12a respectivement 12b, relié par une première entrée à la sortie du convertisseur analogique numérique 10. Les deuxièmes entrées des deux circuits multiplieurs 12a et 12b sont reliées respectivement à deux sorties en quadrature d'un oscillateur complexe 13. Les sorties des deux voies 11a et 11b sont couplées respectivement aux entrées de deux filtres décimeurs 14a et 14b suivis de deux filtres passe-bas à réponse impulsionnelle finie 15a et 15b. Un circuit d'interface 16 assure l'adaptation entre les sorties des deux filtres 15a et 15b et le dispositif de calcul 7 de la figure 1.

Pour effectuer la mesure de l'impédance Z de l'antenne 3, il est tout d'abord nécessaire de dimensionner les éléments transformateur 1 et atténuateurs 6a et 6b pour que les deux tensions V1 et V2 fournies par les atténuateurs 6a et 6b, soient égales lorsque l'enroulement primaire du transformateur 1 est relié, par l'intermédiaire du commutateur 8, en série avec une résistance étalon Re qui est choisie de préférence égale à l'impédance caractéristique de l'antenne 3. Cet ajustement permet de normaliser le calcul de l'impédance Z de l'antenne 3. Les tensions V1 et V2 sont ensuite échantillonnées simultanément en phase et en quadrature par chaque convertisseur analogique/numérique 10 et circuits multiplieurs 12a, 12b de manière à mesurer leur module et leur phase et calculer le rapport des modules (Z) et la différence de phase φ, en normalisant les résultats par rapport à la résistance étalon Re, pour en déduire les parties réelle et réactive de l'impédance complexe de l'antenne 3. Ce calcul est effectué en application des relations :

$$|Z| = Re. \frac{\sqrt{V_I^2 + V_Q^2}}{\sqrt{V'^2_I + V'^2_Q}} = Re. \frac{V_1}{V_2} \qquad (1)$$

$$\varphi = \text{Arctg}\left[\frac{V_Q}{V_I}\right] - \text{Arctg}\left[\frac{V'_Q}{V'_I}\right] - \pi\,\text{signe}\,(V_I < 0) + \pi\,\text{signe}\,(V'_I < 0). \qquad (2)$$

où $V_I$, $V_Q$ ; $V'_I$, $V'_Q$ désignent respectivement les niveaux de tension des échantillons fournis par les dispositifs de transposition de fréquence sur les voies I et Q,
d'où sont déduites les composantes réelle R et imaginaire X de l'impédance Z de l'antenne 3 par les relations :

$$R = R_E .|Z| \cos(\varphi) \qquad (3)$$

$$X = R_E .|Z|. \sin(\varphi) \qquad (4)$$

Naturellement les valeurs de R et X obtenues par les calculs précédants ne peuvent être considérées comme exactes que dans l'hypothèse d'un dispositif de mesure parfait ce qui dans la pratique risque de n'être malheureusement jamais le cas à cause notamment du transformateur 1 qui restitue un signal dont les caractéristiques d'amplitude et de phase sont variables en fonction de la fréquence et des conditions d'environnement, de température notamment. Il est par conséquent conseillé de procéder à un étalonnage chaque fois que ces paramètres varient de façon significative. En principe, la mesure peut être effectuée sur une seule paire d'échantillons. Dans la pratique il est préférable d'effectuer une moyenne sur plusieurs échantillons ce qui permet d'éliminer du bruit et des parasites éventuels. Une bonne durée d'échantillonnage peut être choisie de l'ordre de 5 ms pour des émetteurs utilisés dans la bande HF. Dans ce cas si l'on considère fixé à 5 ms la durée de stabilisation de l'émetteur, on voit que la mesure peut être exploitée dans un délai de 10 ms ce qui diminue fortement la "signature" de l'émetteur et représente un temps très court, comparé aux réalisations actuelles où il faut attendre plusieurs centaines de millisecondes pour effectuer une mesure d'impédance d'antenne.

Un deuxième avantage important concerne la sélectivité des convertisseurs de fréquence qui peut être aussi bonne que 100 Hz. Ainsi le système est entièrement protégé contre les brouilleurs constitués d'émetteurs proches.

Enfin, un troisième avantage est constitué par la très faible puissance nécessaire pour effectuer la mesure (quelques milliwatts).

Le dispositif qui vient d'être décrit est universel dans son principe et peut être adapté à la mesure d'une impédance réelle de n'importe quel circuit électronique passif.

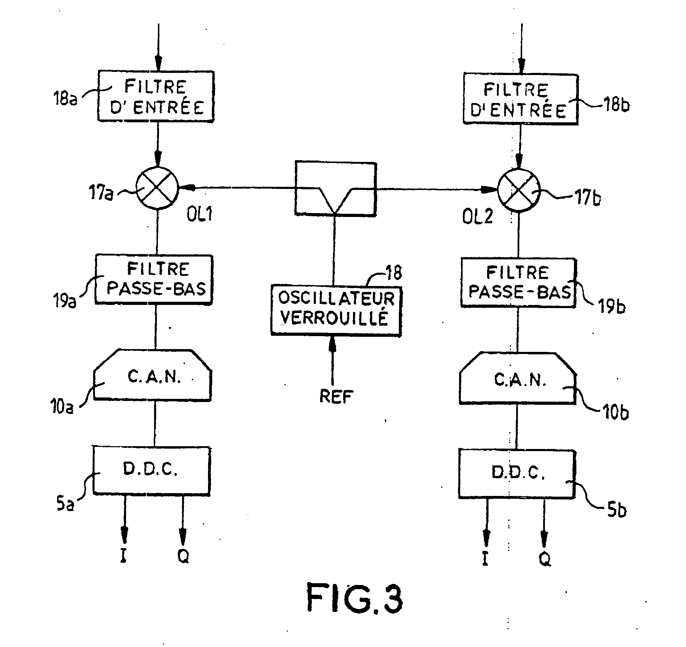

En pratique la bande de fréquence utilisable est limitée à la bande passante des convertisseurs analogique/numérique. Actuellement la bande HF est définie dans la gamme 1,5 à 30 MHz, mais il est possible d'étendre la bande des fréquences en modifiant les dispositifs de transposition de fréquence de la façon représentée à la figure 3, où les éléments homologues à ceux de la figure 1 sont repérés avec les mêmes références. Outre l'utilisation comme sur la figure 1 de deux voies comportant chacune un convertisseur analogique/numérique 10a, 10b et un dispositif de transposition de fréquence 5a et 5b, il est adjoint en amont des convertisseurs analogique/numérique 10a et 10b, un deuxième dispositif de transposition de fréquence 17a, 17b sur chacune des voies, interposé entre deux filtres l'un d'entrée 18a, l'autre passe bas 19a, respectivement 18b, 19b. La nécessité de mettre des filtres dépend de la fréquence de travail.

## Revendications

1. Procédé de mesure d'une impédance d'antenne (3) alimentée par un amplificateur (4), caractérisé en ce qu'il consiste :

   - à transformer en tension la valeur du courant d'alimentation de l'antenne (3) au moyen d'un transformateur (1) dont l'enroulement primaire est traversé par le courant d'alimentation,
   - à désaccoupler (8) dans une première étape l'antenne (3) de l'amplificateur (4) pour charger l'amplificateur (4) sur une résistance étalon Re au travers de l'enroulement primaire du transformateur (1) en rendant égale la tension fournie par l'enroulement secondaire, à celle fournie par la sortie de l'amplificateur (4),
   - à désaccoupler (8) dans une deuxième étape la résistance étalon Re de la sortie de l'amplificateur (4) en reconnectant l'antenne (3) à la sortie de l'amplificateur (4) au travers de l'enroulement primaire du transformateur (1) pour calculer le module et l'argument de l'impédance Z de l'antenne (3) en multipliant par la valeur de la résistance étalon Re, le rapport des tensions fournies respectivement durant cette deuxième étape par la sortie de l'amplificateur (4) et par l'enroulement secondaire du transformateur (1).

2. Procédé selon la revendication 1, caractérisé en ce qu'il consiste à échantillonner les signaux obtenus à la sortie de l'amplificateur (4) et par l'enroulement secondaire du transformateur (1),

   - à répartir les échantillons sur deux voies en quadrature 11a et 11b,
   - à décimer (14a, 14b) dans un même rapport les échantillons sur chacune des voies et
   - à calculer le rapport des tensions et leur déphasage à partir des échantillons décimés sur les voies en quadrature.

3. Dispositif pour la mesure d'une impédance d'antenne (3) alimentée par un amplificateur (4), caractérisé en ce qu'il comprend un transformateur courant/tension (1) couplé par son enroulement primaire entre un dispositif d'accord (2) de l'antenne (3) et la sortie de l'amplificateur (4) un premier (5a) et un deuxième (5b) dispositif de transposition de fréquence numérique en bande de base couplé respectivement à la sortie de l'amplificateur (4) et à l'enroulement secondaire du transformateur (1), et un dispositif de calcul (7) pour calculer l'impédance de l'antenne (3) à partir des signaux fournis par le premier (5a) et le deuxième (5b) dispositif de transposition de fréquence.

4. Dispositif selon la revendication 3, caractérisé en ce que les premier et deuxième dispositif de transposition de fréquence ont une structure identique, et comprennent un convertisseur analogique/numérique (10) couplé à une chaîne de transposition composée de deux voies en quadrature (11a, 11b), chacune des voies comprenant un circuit multiplieur (12a, 12b) relié par une première entrée à la sortie du convertisseur analogique/numérique (10), les deuxièmes entrées des circuits multiplieurs étant reliées respectivement à deux sorties en quadrature d'un oscillateur (13), les sorties des deux voies (11a et 11b) étant couplées respectivement aux entrées de deux filtres décimeurs (14a, 14b) suivis de deux filtres passe-bas (15a, 15b), et un circuit d'interface (16) pour adapter les sorties des filtres (15a, 15b) au dispositif de calcul (7).

5. Dispositif selon l'une des revendications 3 et 4, caractérisé en ce qu'il comprend un dispositif d'étalonnage composé d'un commutateur (8) et d'une impédance étalon Zc=Re disposée entre le transformateur (1) et le dispositif d'accord (2), pour commuter dans une phase d'étalonnage l'enroulement primaire du transformateur (1) en série avec l'impédance étalon et commuter en phase d'émission l'enroulement primaire du transformateur (1) sur l'antenne (3) au travers du dispositif d'accord (2).

6. Dispositif selon la revendication 5, caractérisé en ce que le transformateur 1 est dimensionné pour que les deux tensions fournies par la sortie de l'amplificateur (4) et le secondaire du transformateur (1) soient égales en phase d'étalonnage.

**FIG.1**

**FIG.2**

FIG.3

**Office européen des brevets**

## RAPPORT DE RECHERCHE EUROPEENNE

Numéro de la demande

EP 00 40 2316

### DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.7) |
|---|---|---|---|
| A | DE 197 56 100 A (GRINAKER ELECTRONICS LTD) 8 octobre 1998 (1998-10-08) * abrégé; figures 1,2,4B * | 1,3 | G01R27/04 |
| A | US 5 157 338 A (MOTHERBAUGH JAMES M ET AL) 20 octobre 1992 (1992-10-20) * abrégé; figure 4 * | 1 | |
| A | DE 29 31 757 A (LICENTIA GMBH) 19 février 1981 (1981-02-19) * revendication 2; figure 2 * | 1 | |
| A | US 5 206 600 A (MOEHLMANN RICHARD H) 27 avril 1993 (1993-04-27) * abrégé; figures 1,3,5 * | 3 | |
| A | PATENT ABSTRACTS OF JAPAN vol. 1998, no. 11, 30 septembre 1998 (1998-09-30) & JP 10 163889 A (KOKUSAI ELECTRIC CO LTD), 19 juin 1998 (1998-06-19) * abrégé * | 3 | |
| | | | **DOMAINES TECHNIQUES RECHERCHES (Int.Cl.7)** |
| A | WO 96 39727 A (FLASH COMM INC) 12 décembre 1996 (1996-12-12) * abrégé; figures 1,3,4 * | 1,3 | G01R H03H |

Le présent rapport a été établi pour toutes les revendications

| Lieu de la recherche | Date d'achèvement de la recherche | Examinateur |
|---|---|---|
| BERLIN | 29 novembre 2000 | Fritz, S |

CATEGORIE DES DOCUMENTS CITES

X : particulièrement pertinent à lui seul
Y : particulièrement pertinent en combinaison avec un autre document de la même catégorie
A : arrière–plan technologique
O : divulgation non–écrite
P : document intercalaire

T : théorie ou principe à la base de l'invention
E : document de brevet antérieur, mais publié à la date de dépôt ou après cette date
D : cité dans la demande
L : cité pour d'autres raisons
........................................................
& : membre de la même famille, document correspondant

EPO FORM 1503 03.82 (P04C02)

**ANNEXE AU RAPPORT DE RECHERCHE EUROPEENNE**
**RELATIF A LA DEMANDE DE BREVET EUROPEEN NO.**

EP 00 40 2316

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

29-11-2000

| Document brevet cité au rapport de recherche | Date de publication | Membre(s) de la famille de brevet(s) | Date de publication |
|---|---|---|---|
| DE 19756100 A | 08-10-1998 | AUCUN | |
| US 5157338 A | 20-10-1992 | AUCUN | |
| DE 2931757 A | 19-02-1981 | AUCUN | |
| US 5206600 A | 27-04-1993 | US 5386194 A | 31-01-1995 |
| JP 10163889 A | 19-06-1998 | AUCUN | |
| WO 9639727 A | 12-12-1996 | US 5589844 A | 31-12-1996 |
| | | AU 5871096 A | 24-12-1996 |

EPO FORM P0460

Pour tout renseignement concernant cette annexe : voir Journal Officiel de l'Office européen des brevets, No.12/82